# EUROPEAN PATENT APPLICATION

(11) **EP 4 804 740 A1**
(43) Date of publication of application: **09.09.2026**
(21) Application number: 24885842.5
(22) Date of filing: 31.10.2024
(51) Int. Cl.: H05K 3/46

(54) **WIRING BOARD AND SEMICONDUCTOR DEVICE**

(30) Priority: 31.10.2023 JP 2023186673
(71) Applicant: Kyocera Corporation, Kyoto-shi, Kyoto 612-8501 (JP)
(72) Inventor: ITOU, Seiichirou, Kyoto-shi, Kyoto 612-8501 (JP); GONDO, Iori, Kyoto-shi, Kyoto 612-8501 (JP); HARAZONO, Masaaki, Kirishima-shi, Kagoshima 899-4312 (JP)
(74) Representative: Viering, Jentschura & Partner mbB Patent- und Rechtsanwälte
(86) International application number: PCT/JP2024/038934
(87) International publication number: WO 2025/095076

(57) **Abstract**

A wiring board according to the present disclosure includes a first base member, a second base member containing a plurality of inorganic particles, made of an organic resin, and bonded to the first base member, and a wiring line located in the second base member. The first base member has a higher rigidity than the second base member. The second base member includes a first layer having a relatively low content ratio of the inorganic particles, and a second layer layered on the first layer and having a relatively high content ratio of the inorganic particles. The first layer is in contact with the first base member.

## Description

### TECHNICAL FIELD

The present disclosure relates to a wiring board and a semiconductor device.

### BACKGROUND OF INVENTION

A wiring board is known in which an organic substrate having wiring lines formed thereon is layered on a glass cloth substrate as a core material. The organic substrate contains inorganic particles such as silica (Patent Document 1).

### CITATION LIST

### PATENT LITERATURE

Patent Document 1: JP 2014-27212 A

### SUMMARY

A wiring board according to an aspect of the present disclosure includes: a first base member; a second base member containing a plurality of inorganic particles, the second base member being made of an organic resin and being bonded to the first base member; and a wiring line located in the second base member. The first base member has a higher rigidity than the second base member. The second base member includes a first layer having a relatively low content ratio of the inorganic particles, and a second layer layered on the first layer and having a relatively high content ratio of the inorganic particles. The first layer is in contact with the first base member.

### BRIEF DESCRIPTION OF THE DRAWINGS

FIG. 1 is a schematic cross-sectional view illustrating a state in which a semiconductor device according to a first embodiment is mounted over a motherboard.
FIG. 2 is a schematic cross-sectional view illustrating a configuration of a wiring board according to the first embodiment.
FIG. 3 is a schematic cross-sectional view illustrating a configuration of a second base member according to the first embodiment.
FIG. 4 is a schematic cross-sectional view illustrating a configuration of a first base member and the second base member according to the first embodiment.
FIG. 5 is a schematic cross-sectional view illustrating a configuration of a first layer according to the first embodiment and a periphery thereof.
FIG. 6 is a schematic cross-sectional view illustrating a configuration of a second base member according to a second embodiment.

### DESCRIPTION OF EMBODIMENTS

Modes (hereinafter, referred to as "embodiments") for implementing a wiring board and a semiconductor device according to the present disclosure are described in detail below with reference to the drawings. Note that the present disclosure is not limited by the embodiments. The embodiments can be appropriately combined within a range that does not cause inconsistencies in the processing content. In the following embodiments, the same portions are denoted by the same reference signs, and redundant descriptions are omitted.

In the following embodiments, expressions such as "certain", "orthogonal", "perpendicular", and "parallel" may be used, but these expressions need not mean exactly "certain", "orthogonal", "perpendicular", and "parallel". In other words, each of the expressions described above allows for deviations in, for example, manufacturing accuracy, or installation accuracy.

In the drawings to be referenced below, to facilitate understanding, an orthogonal coordinate system may be defined, in which the X-axis direction, Y-axis direction, and Z-axis direction mutually orthogonal are specified, and the Z-axis positive direction is set as the vertically upward direction.

Inorganic particles have an effect of reducing the thermal expansion coefficient of a base member made of an organic resin and having a relatively high thermal expansion coefficient, but may reduce adhesiveness between the base member made of an organic resin and a core material.

The present disclosure provides a technique capable of improving adhesiveness between a base member made of an organic resin and a core material while reducing the thermal expansion coefficient of the base member made of an organic resin by inorganic particles.

### First Embodiment

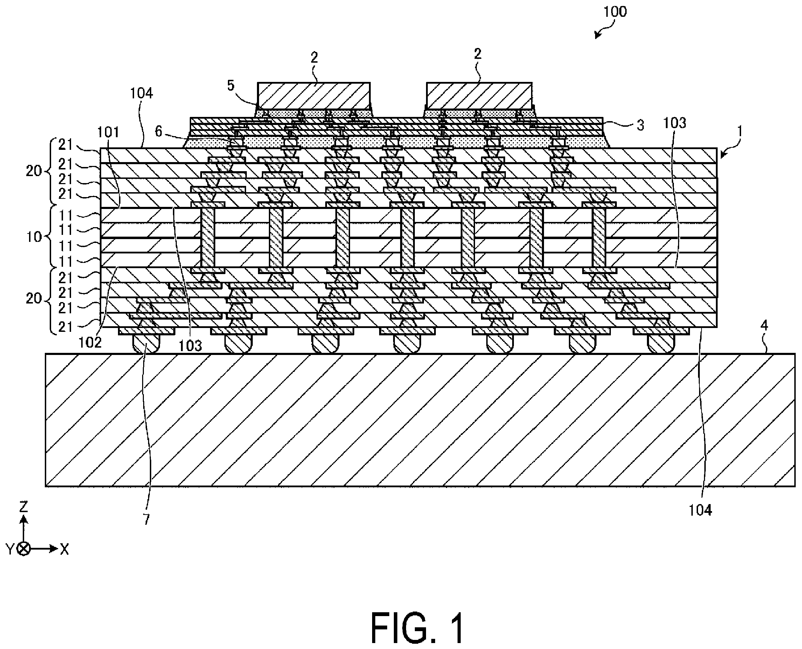

First, a configuration of a semiconductor device 100 according to a first embodiment is described with reference to FIG. 1. FIG. 1 is a schematic cross-sectional view illustrating a state in which the semiconductor device 100 according to the first embodiment is mounted over a motherboard 4.

As illustrated in FIG. 1, the semiconductor device 100 includes a wiring board 1, a plurality of semiconductor elements 2, and a relay substrate 3.

The wiring board 1 is mounted over the motherboard 4. Details of the wiring board 1 are described below.

The semiconductor element 2 is mounted over the wiring board 1 via the relay substrate 3. The semiconductor element 2 is, for example, a chip or a chiplet in which a circuit or an element is formed on a substrate made of a material other than a semiconductor, such as a semiconductor chip or a glass substrate. A chiplet is a functional block constituting a part of an integrated circuit of the semiconductor device 100.

Although FIG. 1 illustrates two semiconductor elements 2, the semiconductor device 100 may include three or more semiconductor elements 2. The semiconductor device 100 may include only one semiconductor element 2. For example, when the semiconductor element 2 is a chiplet, an integrated circuit having one function may be configured by a plurality of semiconductor elements 2.

The relay substrate 3 is a so-called interposer, and relays electrical connection between the wiring board 1 and the semiconductor element 2. The relay substrate 3 is bonded to the semiconductor element 2 via bonding portions 5 and is bonded to the wiring board 1 via bonding portions 6. The bonding portions 5 and 6 are, for example, solder. The Young's modulus of the relay substrate 3 may be smaller than the Young's modulus of the wiring board 1. In this case, the relay substrate 3 may have flexibility that allows the relay substrate 3 to be deformed according to the shape of a surface of the wiring board 1.

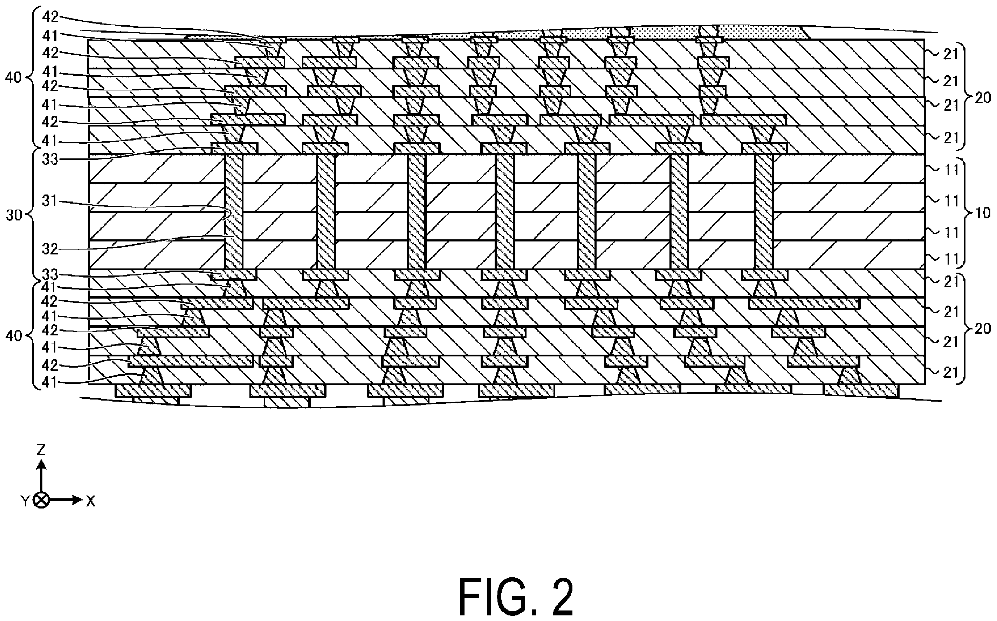

The configuration of the wiring board 1 according to the first embodiment is described with reference to FIG. 2. FIG. 2 is a schematic cross-sectional view illustrating the configuration of the wiring board 1 according to the first embodiment.

The wiring board 1 includes a first base member 10 and a second base member 20. The wiring board 1 is a laminate body of the first base member 10 and the second base member 20. The wiring board 1 includes a first wiring line 30 and a second wiring line 40.

### First Base Member

The first base member 10 is a base member made of ceramic. The first base member 10 may be formed using a ceramic composite material containing a glass component, so-called glass ceramic. The glass ceramic may be any one of a composite of a glass phase and ceramic particles, a composite of a glass phase and a crystal phase formed by crystallization of a part of the glass phase, a form in which ceramic particles are present in a glass phase, and a form in which a glass phase is present at a grain boundary between ceramic particles. The first base member 10 formed using ceramic in this manner has a higher rigidity than a core material made of glass.

For example, the first base member 10 may be low temperature co-fired ceramics (LTCC). When LTCC is used as the first base member 10, a metal having a low melting point such as copper or silver having a relatively low electric resistance can be used as the wiring line. In the present embodiment, the metal having a low melting point is a metal having a lower melting point than a general metal used for a wiring line of a ceramic base member, for example, tungsten or molybdenum.

The first base member 10 may include a ceramic filler as the ceramic particles. As the ceramic filler, for example, alumina (aluminum oxide), calcium titanate, magnesium titanate, or the like can be used. In particular, the first base member 10 including alumina has a high rigidity.

The first base member 10 has a first surface 101 and a second surface 102 opposite to the first surface 101. The first base member 10 may be a plate-shaped body having the first surface 101 and the second surface 102 as main surfaces.

In the first embodiment, the first base member 10 includes a plurality of ceramic layers 11. The plurality of ceramic layers 11 are layered along the thickness direction of the first base member 10. The wiring board 1 including such a first base member 10 has a high degree of freedom in design. By configuring the first base member 10 using the plurality of ceramic layers 11, the first base member 10 can be produced while checking whether the first wiring line 30 is appropriately formed for each layer, so that the yield of the first base member 10 can be improved.

In the example illustrated in FIGs. 1 and 2, the first base member 10 includes four ceramic layers 11; however, the number of the ceramic layers 11 is not limited to four. The number of the ceramic layers 11 may be two or three, or may be five or more.

### Second Base Member

The second base member 20 is a base member including an organic component. The organic component may be an organic resin. The organic resin may be, for example, an epoxy resin, an acrylic resin, a polycarbonate resin, a polyimide resin, an olefin resin, a polyphenylene resin, or the like.

The organic resin may be, for example, polytetrafluoroethylene (PTFE), or other fluororesin or polyphenylene ether resin. The second base member 20 may include a component other than the organic resin. In the present disclosure, the organic resin may be, for example, a material that accounts for 30 mass% or more of the material constituting the second base member 20.

The second base member 20 includes a third surface 103 and a fourth surface 104 opposite to the third surface 103. The second base member 20 may be a plate-shaped body having the third surface 103 and the fourth surface 104 as main surfaces.

The wiring board 1 according to the first embodiment includes two second base members 20. Specifically, one of the two second base members 20 is bonded to the first surface 101 of the first base member 10, and the other is bonded to the second surface 102 of the first base member 10.

The second base member 20 located on the first surface 101 of the first base member 10 includes the third surface 103 bonded to the first surface 101 of the first base member 10, and the plurality of semiconductor elements 2 are mounted on the fourth surface 104 of the second base member 20 via the relay substrate 3 (see FIG. 1).

The second base member 20 located on the second surface 102 of the first base member 10 includes the third surface 103 bonded to the first surface 101 of the first base member 10, and the fourth surface 104 of the second base member 20 is bonded to the motherboard 4 via bonding portions 7.

The second base member 20 includes a plurality of organic resin layers 21. The plurality of organic resin layers 21 are layered along the thickness direction of the second base member 20. The wiring board 1 including such a second base member 20 has a high degree of freedom in design. In the example illustrated in FIG. 2, the second base member 20 includes four organic resin layers 21; however, the number of the organic resin layers 21 is not limited to four. The number of the organic resin layers 21 may be two or three, or may be five or more.

In the example illustrated in FIGs. 1 and 2, the wiring board 1 includes the second base member 20 on each of both main surfaces (the first surface 101 and the second surface 102) of the first base member 10. The wiring board 1 is not limited thereto, and may include the second base member 20 on at least the first surface 101 of the first base member 10.

The second base member 20 including an organic component is more likely to form a fine wiring pattern than an inorganic substrate. On the other hand, the first base member 10 made of ceramic has a higher rigidity than the second base member 20 and a lower density than the second base member 20.

The wiring board 1 according to the first embodiment can increase the rigidity while achieving miniaturization and a narrow pitch of the wiring line by combining the first base member 10 and the second base member 20. Since the warpage of the substrate is more likely to be actualized as the substrate becomes larger, the configuration of the wiring board 1 in which the low rigidity of the second base member 20 is compensated for by the first base member 10 is particularly useful in increasing the size of the substrate.

The first base member 10 and the second base member 20 are bonded to each other by, for example, hydrogen bonding. Specifically, the first base member 10 and the second base member 20 are bonded to each other by bonding the hydroxyl groups of the first base member 10 and the second base member 20 to each other. In this case, a ceramic material such as alumina having a surface hydroxyl group may be used for the first base member 10, and an epoxy resin, which is a resin material including a hydroxyl group, may be used for the second base member 20. In this manner, the first base member 10 and the second base member 20 are directly bonded to each other without solder, underfill, or the like interposed therebetween, so that the thickness of the wiring board 1 can be suppressed and the manufacturing process can be facilitated.

The first base member 10 may contain a glass component, and the second base member 20 may contain a coupling agent chemically bonding with the glass component. As the coupling agent, for example, a silane coupling agent can be used. As the coupling agent, a titanium-based coupling agent or an aluminum-based coupling agent can also be used. According to such a configuration, the first base member 10 and the second base member 20, which are different materials, can be more firmly bonded to each other by chemically bonding the first base member 10 and the second base member 20.

### First wiring line

The first wiring line 30 is a through-hole conductor located in the first base member 10. Specifically, the first wiring line 30 includes a through hole 31 penetrating the first base member 10 and a conductor 32. The conductor 32 includes metal as a main component and is located inside the through hole 31.

The first wiring line 30 includes a land portion 33 on the first surface 101 and the second surface 102 of the first base member 10.

### Second wiring line

The second wiring line 40 includes a plurality of vias 41 and one or more wiring layers 42. The via 41 penetrates one or more organic resin layers 21. The wiring layer 42 is located between the adjacent organic resin layers 21 and electrically connects the plurality of vias 41. The second wiring line 40 may include a land portion located on the fourth surface 104 of the second base member 20.

The first wiring line 30 and the second wiring line 40 may be, for example, metal conductors including copper or silver as a main component. For example, both the first wiring line 30 and the second wiring line 40 may be metal conductors including copper as a main component. Both the first wiring line 30 and the second wiring line 40 may be metal conductors including silver as a main component. One of the first wiring line 30 and the second wiring line 40 may be a metal conductor including copper as a main component, and the other may be a metal conductor including silver as a main component.

By using a metal conductor including copper or silver as a main component for all of the first wiring line 30 and the second wiring line 40, high electrical characteristics can be obtained compared to a case where, for example, one of the first wiring line 30 and the second wiring line 40 is a metal conductor other than copper and silver.

Out of the first wiring line 30 and the second wiring line 40, only the first wiring line 30 may contain a glass component. In this case, the first wiring line 30 is firmly bonded to the first base member 10, which also contains a glass component, via the glass component. Therefore, the rigidity of the first base member 10 can be increased.

In a firing step in the production of the wiring board 1, the shrinkage rates of the first base member 10 and the first wiring line 30 can be made uniform to some extent, which can help prevent a position shift of the first wiring line 30.

The first wiring line 30 may be formed by, for example, printing a conductor paste containing copper and a glass component on a green sheet that is a raw material of the ceramic layer 11 and simultaneously firing the conductor paste and the green sheet. Specifically, the conductor paste may contain, for example, copper powder, borosilicate glass powder, and silica particles.

On the other hand, the second wiring line 40 may be formed by copper plating. Thus, out of the first wiring line 30 and the second wiring line 40, only the first wiring line 30 may contain a glass component.

The second wiring line 40 may be electrically and thermally connected to the semiconductor element 2 via the relay substrate 3. The second wiring line 40 including copper or silver having a relatively high thermal conductivity as a main component is thermally connected to the semiconductor element 2 serving as a heat source, so that heat generated from the semiconductor element 2 can be efficiently released via the second wiring line 40 and the first wiring line 30.

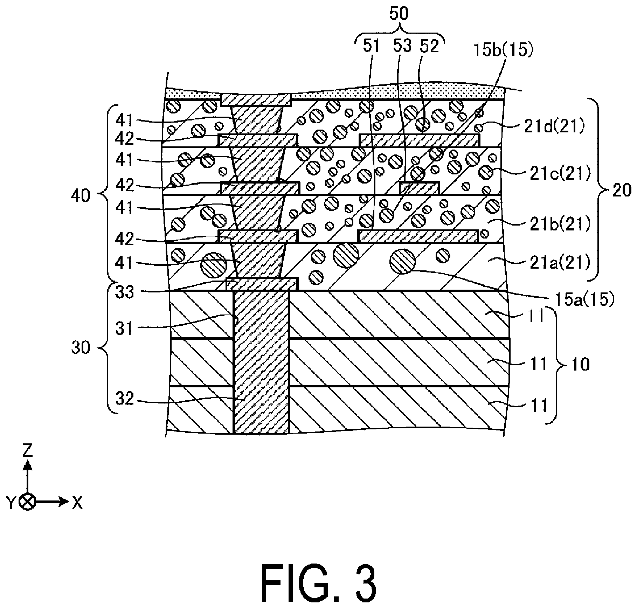

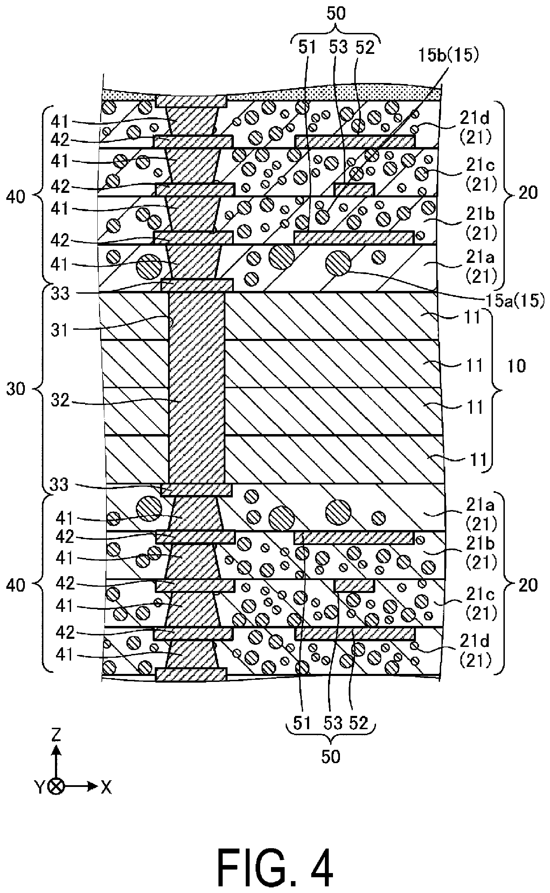

The configuration of the second base member 20 according to the first embodiment is described with reference to FIGs. 3 and 4. FIG. 3 is a schematic cross-sectional view illustrating the configuration of the second base member 20 according to the first embodiment. FIG. 4 is a schematic cross-sectional view illustrating the configuration of the first base member 10 and the second base member 20 according to the first embodiment.

As described above, the second base member 20 includes the plurality of organic resin layers 21. Specifically, the plurality of organic resin layers 21 include a first layer 21a in contact with the first base member 10, and second layers 21b to 21d layered on the first layer 21a. In other words, the second layers 21b to 21d are all the organic resin layers 21 that are not in contact with the first base member 10 among the plurality of organic resin layers 21. In the second layers 21b to 21d, a first organic resin layer 21b, a second organic resin layer 21c, and a third organic resin layer 21d are layered in this order.

As illustrated in FIG. 3, the second base member 20, that is, the first layer 21a and the second layers 21b to 21d include inorganic particles 15. The inorganic particles 15 are, for example, silica. The inorganic particles 15 are not limited to silica, and may be alumina, magnesium oxide, zirconia, calcium oxide, calcium carbonate, or the like.

The inorganic particles 15 have an effect of reducing the thermal expansion coefficient of the second base member 20 made of an organic resin and having a relatively high thermal expansion coefficient. However, when the inorganic particles 15 are located at an interface between the first base member 10 and the second base member 20, since a contact area between the first base member 10 and the second base member 20 is reduced, the adhesiveness between the first base member 10 and the second base member 20 may be reduced.

In the wiring board 1 according to the first embodiment, the content ratio of the inorganic particles 15 in the first layer 21a is relatively reduced. Specifically, as illustrated in FIG. 3, the content ratio of the inorganic particles 15 in the first layer 21a of the second base member 20 is lower than the content ratio of the inorganic particles 15 in the second layers 21b to 21d. In other words, the content ratio of the inorganic particles 15 in the second layers 21b to 21d of the second base member 20 is higher than the content ratio of the inorganic particles 15 in the first layer 21a.

According to such a configuration, the amount of the inorganic particles 15 located at the interface between the first base member 10 and the second base member 20 can be reduced as compared to the wiring board of the related art. Accordingly, the wiring board 1 according to the first embodiment can increase the adhesion strength between the first base member 10 and the second base member 20 while reducing the thermal expansion coefficient of the second base member 20 made of an organic resin by the inorganic particles 15.

The first layer 21a and the second layers 21b to 21d having different content ratios of the inorganic particles 15 can be formed by, for example, adjusting the amount of the inorganic particles 15 contained in an organic resin sheet as a material of the organic resin layer 21 in the step of producing the second base member 20.

The content ratio of the inorganic particles 15 in the second layers 21b to 21d is preferably equal to or higher than 40 wt% and equal to or lower than 80 wt%. The average particle size of the inorganic particles 15 in the second layers 21b to 21d is preferably equal to or greater than 0.1 µm and equal to or less than 0.5 µm.

The maximum particle size of the inorganic particles 15 in the second layers 21b to 21d is preferably equal to or less than 10 times the average particle size. For example, when the average particle size of the inorganic particles 15 in the second layers 21b to 21d is 0.1 µm, the maximum particle size of the inorganic particles 15 is preferably 1 µm or less, and when the average particle size is 0.5 µm, the maximum particle size of the inorganic particles 15 is preferably 5 µm or less.

The wiring board 1 according to the first embodiment may further include a third wiring line 50. The third wiring line 50 is located in the second layers 21b to 21d. The third wiring line 50 includes a first ground wiring line 51, a second ground wiring line 52, and a signal line 53.

Specifically, the first ground wiring line 51 is located in the first organic resin layer 21b and is connected to the ground. The second ground wiring line 52 is located in the third organic resin layer 21d and is connected to the ground. The signal line 53 is located in the second organic resin layer 21c and faces the first ground wiring line 51 and the second ground wiring line 52. The first ground wiring line 51 and the second ground wiring line 52 are so-called solid patterns, and have a larger lateral width (wiring line width) than the signal line 53.

The second base member 20 containing the inorganic particles 15 has a smaller dielectric loss than a second base member containing no inorganic particles. That is, the inorganic particles 15 have an effect of improving the electrical characteristics of the second base member. Accordingly, by positioning the third wiring line 50 in the second layers 21b to 21d having a relatively high content ratio of the inorganic particles 15, a wiring board having high electrical characteristics can be obtained.

When a strip line (a configuration in which a signal line is sandwiched between ground surfaces on the front and back sides via an insulation layer) is provided as a wiring line, the electrical characteristics of the strip line (the propagation speed of an electrical signal in the signal line) can be enhanced by relatively increasing the content ratio of the inorganic particles 15 in the first organic resin layer 21b where the first ground wiring line 51 is located, the second organic resin layer 21c where the signal line 53 is located, and the third organic resin layer 21d where the second ground wiring line 52 is located.

As illustrated in FIG. 3, the average particle size of inorganic particles 15a contained in the first layer 21a may be equal to or greater than the average particle size of the inorganic particles 15b contained in the second layers 21b to 21d. The average particle size of the inorganic particles 15a contained in the first layer 21a may be larger than the average particle size of the inorganic particles 15b contained in the second layers 21b to 21d.

For example, when the size of the contact area between the first base member 10 and the second base member 20 (the first layer 21a) is compared between two first layers having the same content ratio (mass percent) of inorganic particles, one of which contains inorganic particles having a relatively small average particle size and the other of which contains inorganic particles having a relatively large average particle size, the first layer containing the inorganic particles having a relatively small average particle size has a larger contact area with the first base member 10. That is, the first layer containing the inorganic particles having a relatively small average particle size has a lower adhesion strength with the first base member 10. In the wiring board 1 according to the first embodiment, the average particle size of the inorganic particles 15a contained in the first layer 21a is set to be larger than the average particle size of the inorganic particles 15b contained in the second layers 21b to 21d. This can increase the adhesion strength between the first layer 21a and the first base member 10, compared to when the average particle size of the inorganic particles 15 contained in the first layer 21a is the same as the average particle size of the inorganic particles 15b contained in the second layers 21b to 21d, for example.

On the other hand, since the average particle size of the inorganic particles 15b contained in the second layers 21b to 21d is relatively small, miniaturization of the wiring line is easily implemented. Therefore, the third wiring line 50 is suitably positioned.

As illustrated in FIG. 4, the wiring board 1 according to the first embodiment includes two second base members 20. One of the two second base members 20 is bonded to the first surface 101 of the first base member 10, and the other is bonded to the second surface 102 of the first base member 10. The two second base members 20 include the third wiring line 50 located in the second layers 21b to 21d, respectively.

In this case, the third wiring line 50 located in the second base member 20 bonded to the first surface 101 of the first base member 10 and the third wiring line 50 located in the second base member 20 bonded to the second surface 102 are electrically connected via the conductor 32 penetrating the first base member 10. Thus, the third wiring line 50 can be made denser.

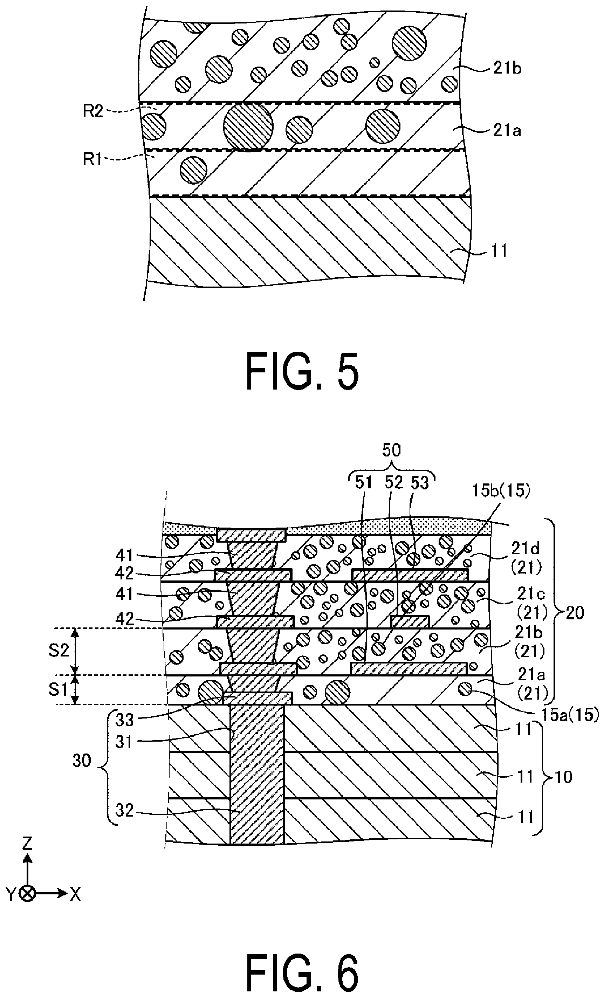

The configuration of the first layer 21a according to the first embodiment and a periphery thereof is described with reference to FIG. 5. FIG. 5 is a schematic cross-sectional view illustrating the configuration of the first layer 21a according to the first embodiment and a periphery thereof.

As illustrated in FIG. 5, when the first layer 21a is virtually divided into two regions R1 and R2 arranged in the thickness direction, the content ratio of the inorganic particles 15 in the region R1, of the two regions R1 and R2, on a side in contact with the first base member 10 may be lower than the content ratio of the inorganic particles 15 in the region, of the two regions R1 and R2, on an R2 side in contact with the second layer 21b. This can further increase the adhesion strength between the first base member 10 and the first layer 21a.

Examples of a method for relatively reducing the content ratio of the inorganic particles 15 in the region R1 include a method in which the region R1 of the organic resin sheet as a material of the organic resin layer 21 is etched with nitrohydrofluoric acid in the step of producing the second base member 20. This melts the inorganic particles 15 included in the region R1 of the organic resin sheet, and thus the content ratio of the inorganic particles 15 in the region R1 can be reduced.

As described above, in the wiring board 1 according to the first embodiment, the content ratio of the inorganic particles 15 in the first layer 21a is relatively reduced. According to such a configuration, the amount of the inorganic particles 15 located at the interface between the first base member 10 and the second base member 20 can be reduced as compared to the wiring board of the related art. Accordingly, the wiring board 1 according to the first embodiment can increase the adhesion strength between the first base member 10 and the second base member 20 while reducing the thermal expansion coefficient of the second base member 20 made of an organic resin by the inorganic particles.

### Second Embodiment

FIG. 6 is a schematic cross-sectional view illustrating the configuration of the second base member 20 according to a second embodiment. The thickness of the first layer 21a of the second base member 20 may be equal to or less than the thickness of the organic resin layer included in the second layers 21b to 21d. The thickness of the first layer 21a of the second base member 20 may be less than the thickness of the organic resin layer included in the second layers 21b to 21d. In the example illustrated in FIG. 6, the thickness S1 of the first layer 21a is less than the thickness S2 of the first organic resin layer 21b. The first layer 21a is thinner than the second organic resin layer 21c and the third organic resin layer 21d.

The first layer 21a having a relatively low content ratio of the inorganic particles 15 has a higher thermal expansion coefficient than the second layer 21b having a relatively high content ratio of the inorganic particles 15. In contrast, by setting the thickness of the first layer 21a to be equal to or less than the thickness of the second layer 21b, the adhesiveness between the first base member 10 and the second base member 20 by the first layer 21a can be improved while reducing the influence of the heat expansion of the first layer 21a as much as possible.

Note that the present technique can also have the following configurations.
(1) A wiring board (for example, the wiring board 1) includes a first base member (for example, the first base member 10), a second base member (for example, the second base member 20) that contains a plurality of inorganic particles (for example, the inorganic particles 15), is made of an organic resin, and is bonded to the first base member, and a wiring line (for example, the third wiring line 50) located in the second base member. The first base member has a higher rigidity than the second base member. The second base member includes a first layer (for example, the first layer 21a) having a relatively low content ratio of the inorganic particles and a second layer (for example, the second layers 21b to 21d) layered on the first layer and having a relatively high content ratio of the inorganic particles. The first layer is in contact with the first base member.
(2) In the wiring board according to (1), the wiring line may include a signal line (for example, the signal line 53), and the signal line may be located in the second layer of the second base member.
(3) In the wiring board according to (1), the second layer may have a structure in which a first organic resin layer (for example, the first organic resin layer 21b), a second organic resin layer (for example, the second organic resin layer 21c), and a third organic resin layer (for example, the third organic resin layer 21d) are layered in this order, the wiring line may include a first ground wiring line (for example, the first ground wiring line 51) located in the first organic resin layer and connected to a ground, and a second ground wiring line (for example, the second ground wiring line 52) located in the third organic resin layer and connected to the ground, and the signal line may be located in the second organic resin layer and face the first ground wiring line and the second ground wiring line.
(4) In the wiring board according to (1), the second layer may include a plurality of organic resin layers, and a thickness of the first layer may be equal to or less than a thickness of the organic resin layer included in the second layer.
(5) In the wiring board according to any one of (1) to (4), an average particle size of the inorganic particles contained in the first layer may be equal to or greater than an average particle size of the inorganic particles contained in the second layer.
(6) In the wiring board according to any one of (1) to (5), the first base member may be made of ceramic.
(7) In the wiring board according to any one of (1) to (6), the first base member may include a plurality of ceramic layers.
(8) The wiring board according to any one of (1) to (7) may include two second base members, the first base member may have a first surface (for example, the first surface 101) and a second surface (for example, the second surface 102) opposite to the first surface, and the second base members may be bonded to the first surface and the second surface, respectively.
(9) The wiring board according to (8) may include a conductor (for example, the conductor 32) penetrating the first surface and the second surface of the first base member, and the wiring line located in the second base member bonded to the first surface and the wiring line located in the second base member bonded to the second surface may be electrically connected via the conductor.
(10) In the wiring board according to any one of (1) to (9), the first base member may contain a glass component, and the first layer of the second base member may contain a coupling agent chemically bonding with the glass component.
(11) In the wiring board according to any one of (1) to (10), when the first layer is virtually divided into two regions arranged in a thickness direction, a content ratio of the inorganic particles in a region, of the two regions, on a side in contact with the first base member may be lower than a content ratio of the inorganic particles in a region, of the two regions, on a side in contact with the second layer.
(12) In the wiring board according to any one of (1) to (11), a content ratio of the inorganic particles in the second layer may be equal to or higher than 40 wt% and equal to or lower than 80 wt%, an average particle size of the inorganic particles may be equal to or greater than 0.1 µm and equal to or less than 0.5 µm, and a maximum particle size of the inorganic particles may be equal to or less than 10 times the average particle size.
(13) A semiconductor device (for example, the semiconductor device 100) may include the wiring board according to any one of (1) to (12); and a semiconductor element (for example, the semiconductor element 2) mounted over the second base member of the wiring board.

The embodiments disclosed herein should be considered exemplary in all respects and not restrictive. The embodiments described above may be embodied in various forms. The above-described embodiments may be omitted, substituted, or modified in various forms without departing from the scope and spirit of the appended claims.

### REFERENCE SIGNS

1 Wiring board
2 Semiconductor element
3 Relay substrate
10 First base member
11 Ceramic layer
15 Inorganic particle
20 Second base member
21 Organic resin layer
21a First layer
21b to 21d Second layer
30 First wiring line
31 Through hole
32 Conductor
40 Second wiring line
50 Third wiring line
100 Semiconductor device

## Claims

1. A wiring board comprising:
a first base member;
a second base member containing a plurality of inorganic particles, the second base member being made of an organic resin and being bonded to the first base member; and
a wiring line located in the second base member,
wherein the first base member has a higher rigidity than the second base member,
the second base member comprises
a first layer having a relatively low content ratio of the inorganic particles, and
a second layer layered on the first layer and having a relatively high content ratio of the inorganic particles, and
the first layer is in contact with the first base member.

2. The wiring board according to claim 1,
wherein the wiring line comprises a signal line, and
the signal line is located in the second layer of the second base member.

3. The wiring board according to claim 2,
wherein the second layer has a structure in which a first organic resin layer, a second organic resin layer, and a third organic resin layer are layered in this order,
the wiring line comprises
a first ground wiring line located in the first organic resin layer and connected to a ground, and
a second ground wiring line located in the third organic resin layer and connected to the ground, and
the signal line is located in the second organic resin layer and faces the first ground wiring line and the second ground wiring line.

4. The wiring board according to claim 1,
wherein the second layer comprises a plurality of organic resin layers, and
a thickness of the first layer is equal to or less than a thickness of the organic resin layer comprised in the second layer.

5. The wiring board according to any one of claims 1 to 4, wherein an average particle size of the inorganic particles contained in the first layer is equal to or greater than an average particle size of the inorganic particles contained in the second layer.

6. The wiring board according to any one of claims 1 to 5, wherein the first base member is made of ceramic.

7. The wiring board according to claim 6, wherein the first base member comprises a plurality of ceramic layers.

8. The wiring board according to claim 6 or 7, comprising:
two second base members each being the second base member,
the first base member has
a first surface, and
a second surface opposite to the first surface, and
the second base members are bonded to the first surface and the second surface, respectively.

9. The wiring board according to claim 8, further comprising:
a conductor penetrating the first surface and the second surface of the first base member,
wherein the wiring line located in the second base member bonded to the first surface and the wiring line located in the second base member bonded to the second surface are electrically connected via the conductor.

10. The wiring board according to any one of claims 6 to 9,
wherein the first base member contains a glass component, and
the first layer of the second base member contains a coupling agent chemically bonding with the glass component.

11. The wiring board according to any one of claims 1 to 10, wherein, when the first layer is virtually divided into two regions arranged in a thickness direction, a content ratio of the inorganic particles in a region, of the two regions, on a side in contact with the first base member is lower than a content ratio of the inorganic particles in a region, of the two regions, on a side in contact with the second layer.

12. The wiring board according to any one of claims 1 to 11,
wherein a content ratio of the inorganic particles in the second layer is equal to or higher than 40 wt% and equal to or lower than 80 wt%,
an average particle size of the inorganic particles is equal to or greater than 0.1 µm and equal to or less than 0.5 µm, and
a maximum particle size of the inorganic particles is equal to or less than 10 times the average particle size.

13. A semiconductor device comprising:
the wiring board according to any one of claims 1 to 12; and
a semiconductor element mounted over the second base member of the wiring board.
